# EUROPEAN PATENT APPLICATION

(11) **EP 2 006 411 A1**
(43) Date of publication of application: **24.12.2008**
(21) Application number: 07011994.6
(22) Date of filing: 19.06.2007
(51) Int. Cl.: C23C 14/12, C23C 14/24, C23C 14/56

(54) **Evaporation apparatus having a rotatable evaporation unit receptacle**

(71) Applicant: Applied Materials, Inc., Santa Clara, CA 95054 (US)
(72) Inventor: Grimm, Helmut, Dr., 64291 Darmstadt (DE)
(74) Representative: Zimmermann, Gerd Heinrich

(57) **Abstract**

The present invention relates to thin-film coating. An evaporation apparatus is provided with a rotatable evaporation unit receptacle having a multitude of chambers wherein each of the chambers is adapted for receiving at least one evaporation unit. Further, a method is provided for evaporating substrates with the steps of placing an evaporation unit in a chamber of an evaporation apparatus evaporation unit receptacle, the chamber having a first atmosphere; and rotating the evaporation unit receptacle so that the chamber is in a second atmosphere.

## Description

### FIELD OF THE INVENTION

The present invention relates to vacuum coating. Particularly, the present invention relates to thin-film forming apparatuses and a method for coating substrates. More specifically, it relates particularly to an evaporation apparatus and an evaporation method for use in the production of organic light emitting diodes.

### BACKGROUND OF THE INVENTION

For thin-film coating of a material on a substrate, an evaporation apparatus can be used. For example, coatings with metal films, which e.g. provide a capacitor of a large panel display or a protective layer on a flexible substrate can be applied with evaporation apparatuses.

The technique of vacuum coating requires both the substrate, which is to be coated, and the evaporation unit to be located in a vacuum atmosphere. The evaporation unit may be a crucible or an evaporation helix. It is known in the state of the art to position the evaporation unit within a vacuum chamber and to pump out the air from the chamber. Once an acceptable level of low pressure within the chamber is reached, the coating of substrates can begin. However, during coating the amount of material to be evaporated decreases. When the material is totally consumed or the material is consumed such that the coating rate decreases significantly, the material to be evaporated has to be replenished. In order to do so, it is known in the state of the art to open the vacuum chamber and refill the material. In doing so, however, the vacuum chamber is aired so that the complete chamber has to be brought to vacuum level after refilling the material for coating.

In particular, vacuum coating with organic evaporators is an essential tool for certain production types of organic light-emitting diodes (OLED). OLEDs are a special type of light-emitting diodes in which the emissive layer comprises a thin-film of certain organic compounds. Such systems can be used in television screens, computer displays, portable system screens, and so on. OLEDs can also be used for general room illumination. The range of colours, brightness, and viewing angles possible with OLED displays are greater than that of traditional LCD displays because OLED pixels directly emit light and do not require a back light. The energy consumption of OLED display is therefore considerably less than that of traditional LCD displays. Further, the fact that OLEDs can be coated onto flexible substrates opens the door to new applications such as roll-up displays or even displays embedded in clothing.

### SUMMARY OF THE INVENTION

In light of the above, the present invention provides an evaporation apparatus according to claim 1 and a method for coating a substrate according to claim 18.

According to a first aspect of the present invention, an evaporation apparatus is provided having a rotatable evaporation unit receptacle with a multitude of chambers wherein each of the chambers is adapted for receiving at least one evaporation unit.

According to another aspect of the present invention, a method is provided for coating substrates with the steps of placing an evaporation unit in a chamber of an evaporation apparatus evaporation unit receptacle, the chamber having a first atmosphere; and rotating the evaporation unit receptacle so that the chamber is in a second atmosphere.

Further advantages, features, aspects and details that can be combined with the above embodiments are evident from the dependent claims, the description and the drawings.

Embodiments are also directed to apparatuses for carrying out the disclosed methods and including apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description. Also, some aspects are illustrated with reference to the figures. Therein:

Figs. 1A shows a first embodiment and Fig. 1B shows a second embodiment of a rotatable evaporation unit receptacle of the evaporation apparatus according to the present invention;

Figs. 2A to 2D show various embodiments of the evaporation apparatus according to the present invention;

Figs. 3A to 3D show various embodiments of chambers of the rotatable evaporation unit receptacle of the evaporation apparatus according to the present invention;

Figs. 4A to 4B show two embodiments of the evaporation apparatus according to the present invention;

Figs. 5A and 5B show further embodiments of the rotatable evaporation unit receptacle of the evaporation apparatus according to the present invention;

Fig. 6 shows a further embodiment of the evaporation apparatus according to the present invention in a horizontal cross-sectional view.

Fig. 7A is a detailed vertical cross-sectional view of an embodiment of the evaporation apparatus according to the present invention;

Fig. 7B is a detailed horizontal cross-sectional view of an embodiment of the evaporation apparatus according to the present invention perpendicular to the cross-sectional view as shown in Fig. 7A;

Fig. 8A shows an embodiment of the rotatable evaporation unit receptacle of the evaporation apparatus according to the present invention;

Fig. 8B shows an embodiment of the evaporation unit receptacle housing of the evaporation apparatus according to the present invention; and

Fig. 9 shows a schematic view of an embodiment of an evaporation apparatus according to the present invention.

### DETAILED DESCRIPTION OF THE DRAWINGS

Without limiting the scope of the present application, in the following Aluminum is described as a material to be deposited on a substrate. The invention is still directed to metals, alloys or other materials to be evaporated and used for coating of a substrate such as copper, silver, gold, aluminum oxide and metal alloys. Further, without limiting the scope of the present invention, a substrate is typically referred to as a glass substrate as often used for display technology, e.g., displays. Embodiments of the present invention can be applied to thin-film vapor deposition on other substrates and for other technologies, e.g., for flexible substrates or webs. In particular, embodiments of the present invention can be used in OLED production. Typically, the evaporation apparatus according to the present invention is for coating a substrate that has already been coated with organic material or that is still to be coated with organic material. That is, the substrate may be organic light emitting diodes in production.

Further, within the following description, the term "crucible" shall refer to an evaporation unit capable of evaporating an evaporation material for coating a substrate with the evaporation material. Typically, the evaporation material is a metal such as Aluminum. Further, the evaporation material may also be an alloy of two or more metals. The evaporation material is the material that is evaporated during the evaporation and with which the substrate is coated. The evaporation unit according to the present invention is typically heatable to a temperature of between 1.300°C and 1.600°C such as 1.560°C.

Within the following description of the drawings, the same reference numbers refer to the same components. Generally, only the differences with respect to the individual embodiments are described.

Typically, the material to be evaporated is evaporated thermally in the embodiments of the present invention.

In general, and particularly for large panel displays, a substrate, which e.g. can be provided as a large and relatively thin glass plate, is typically vertically positioned in a coating process and coated with a vertical evaporator. The term "relatively thin" in this context refers to typical glass thicknesses of between 0.5 mm and 4.0 mm, typically between 0.5 mm and 1.2 mm such as between 0.5 mm and 0.7 mm or between 0.7 mm and 1.2 mm. The term "vertical evaporator" shall be defined as an evaporator arranged and adapted for coating a vertically oriented substrate. Further, the term "substrate" shall also include films and the like. The substrates that are processed according to the present invention may already be coated with organic material and/or may be coated with organic material in a subsequent process step.

Vertical evaporation as taught by the present invention allows for the continuous in-line production of coated substrates, such as OLEDs. More particularly, vertical evaporation allows the coating of large substrates and the effective preventing of particles on the substrate. Generally, the present invention allows the coating of substrates having arbitrary length and height. In typical embodiments, one evaporator is provided per 30-40 cm height of the substrate. Height in this context refers to the vertical dimension of the substrate as positioned in the evaporation apparatus. For instance, a substrate with a height of 80 cm can be evaporated with an evaporation apparatus having two or three vertical evaporators positioned one above the other.

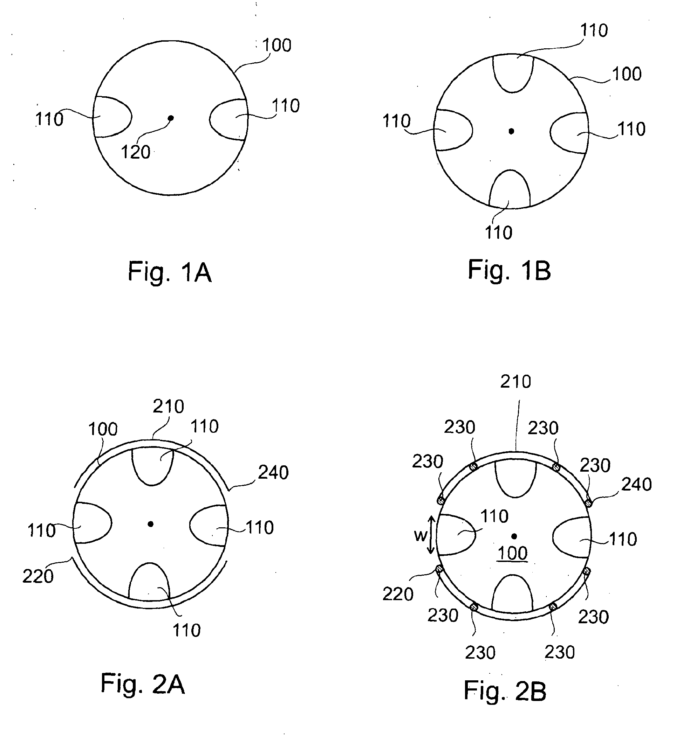

Fig. 1A shows a first embodiment of a rotatable evaporation unit receptacle of the evaporation apparatus according to the present invention. In the cross-section shown in Fig. 1A the reference number 100 refers to the evaporation unit receptacle, the reference number 110 refers to the chambers and the reference number 120 refers to the axis of the evaporation unit receptacle. The evaporation unit receptacle 100 can be rotated along the axis 120. In some of the following figures, the indication of the axis is omitted.

According to the present invention, an evaporation apparatus having a rotatable evaporation unit receptacle with a multitude of chambers is provided. A multitude within the present application shall be understood as at least two. The provision of at least two chambers allows that, in operation of the evaporation apparatus, one chamber is exposed to a first pressure and another chamber is exposed to a second pressure. In typical embodiments, the first pressure is ambient atmosphere whereas the second pressure is vacuum. Vacuum within the present application shall be understood as an atmosphere of between 10⁻² and 10⁻⁶ mbar.

According to another embodiment of the rotatable evaporation unit receptacle, four chambers are provided. This is exemplarily shown in the cross-sectional view of the evaporation unit receptacle 100 having four chambers 110 that is depicted in Fig. 1B.

Fig. 2A is a schematic cross-sectional view of an embodiment of the evaporation apparatus according to the present invention. The evaporation apparatus comprises the rotatable evaporation unit receptacle 100 with four chambers 110. Each of the four chambers is adapted for receiving at least one evaporation unit. An evaporation unit within the present application shall be understood as a crucible or as an evaporation helix. The evaporation apparatus further comprises an evaporation unit receptacle housing 210 within which the evaporation unit receptacle is positioned in a rotatable manner. The evaporation unit receptacle can be rotated within the evaporation unit receptacle housing with the evaporation unit receptacle housing being static. The evaporation unit receptacle housing has typically at least two openings. In typical embodiments of the present invention, the openings are arranged at opposite sides of the housing. This is exemplarily shown in Fig. 2A where the evaporation unit receptacle housing 210 has the opening 220 and the opening 240. The size of the opening is typically adapted to the size of the chambers. That is, the width of the opening in the horizontal direction is typically identical or similar to the width of the chambers in the horizontal direction at the circumference of the evaporation unit receptacle. The height of the opening in the vertical direction is typically identical or similar to the height of the chambers at the circumference of the evaporation unit receptacle. The term "similar" in this context shall include a deviation of ± 15%.

Fig. 2B shows the evaporation apparatus of Fig. 2A with eight sealing lips. The terms gasket, seal, sealing, and sealing gasket are used synonymously within the present application. The sealing lips 230 are positioned between rotatable evaporation unit receptacle 100 and evaporation unit receptacle housing 210. Typically, four of the sealing lips 230 are positioned adjacent to the housing openings which are referred to as 220 and 240 in Fig. 2B. In typical embodiments of the present invention, the number of sealing lips provided between the rotatable evaporation unit receptacle and the evaporation unit receptacle housing for sealing is twice the number of chambers of the evaporation unit receptacle. That is, in the case of four chambers, typically eight sealing lips are provided. Analogously, in the case of two chambers, four sealing lips are provided.

Typically, the distance of the sealing lips to each other is equal to or larger than the width w of the chambers of the evaporation unit receptacle. This way air is prevented from passing from one chamber to its adjacent chamber during the rotation of the evaporation unit receptacle. The sealing lips are vertically oriented. They therefore prevent ambient air from entering the evaporation unit receptacle housing along the evaporation unit receptacle side walls.

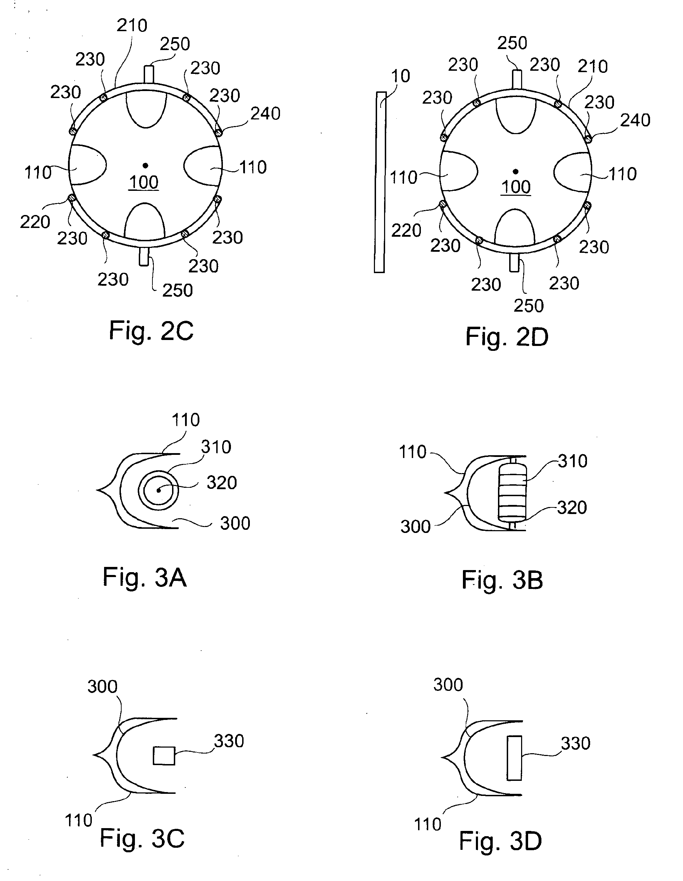

Further, the embodiment depicted in Fig. 2C shows the further provision of vacuum pump connections 250. The vacuum pump connection 250 is typically an outlet in the evaporation unit receptacle housing 210 that is connected to a vacuum pump (not shown) for pumping air out of or into the evaporation unit receptacle housing 210. The outlet(s) in the evaporation unit receptacle housing may be connected to a vacuum pump by a tube or pipe. In typical embodiments of the present invention, the evaporation apparatus has n-2 pump connections and/or (n-2)/2 vacuum pumps with n being the number of chambers provided in the evaporation unit receptacle. As depicted in Figures 2C and 2D, the number of pump connections shown as outlet of the housing that is connected to a tube, is two. Both pump connections 250 depicted may be connected to a single vacuum pump (not shown).

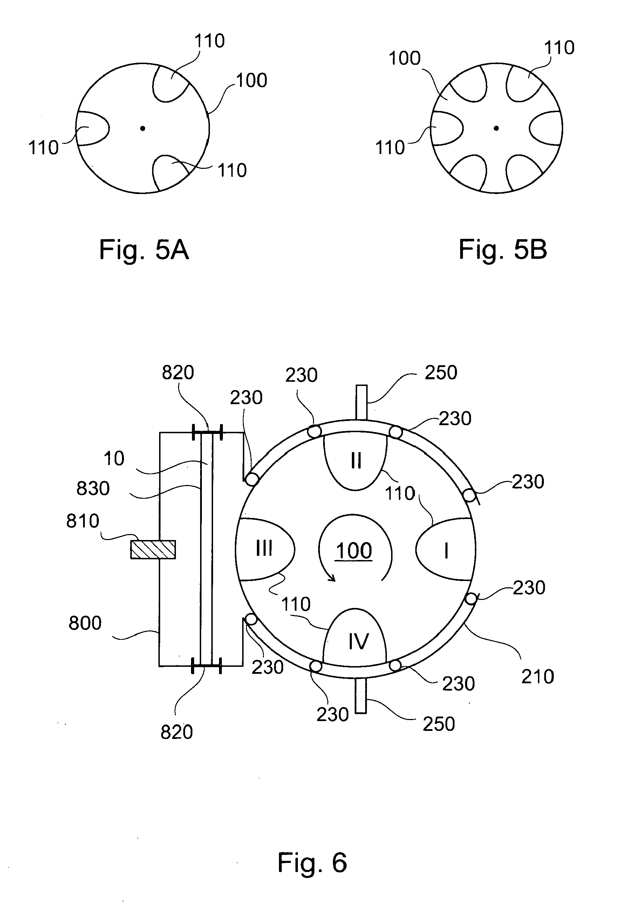

For instance, in typical embodiments of the present invention, two vacuum pump connections are disposed at opposite sides of the evaporation unit receptacle housing. Both vacuum pump connections 250 may be driven by the same vacuum pump (not shown) that pumps the air from and into evaporation unit receptacle housing. Thereby, air is pumped out from the chamber with the reloaded evaporation unit (this chamber's position is shown as position II in Fig. 6) whereas the chamber with the consumed evaporation unit (shown as position IV in Fig. 6) is aired.

Further, the substrate 10 is depicted in Fig. 2D. The term 'substrate' within the present application shall refer to any object that is coated with the evaporation apparatus according to the present invention. In particular, the substrate to be coated can be a glass, a coated glass, plastics, a metal, a foil, a plastic film and the like. The substrate may have been previously coated with organic material. Also, the substrate may still be to be coated with organic material in a subsequent coating step. The substrate may be of any shape. The substrate 10 may move automatically, such as driven by a conveyor belt, and pass the evaporation apparatus with its evaporation unit receptacle and evaporation unit receptacle housing as shown in Fig. 2D. In this event, it is typical that the substrate is moving at a constant speed resulting in a homogeneous coating on the substrate.

As illustrated with respect to the embodiment shown in Fig. 2D, the present invention relates typically to vertical coating. Vertical coating refers to the situation that the substrate to be coated, such as a glass, is oriented vertically. Further, the present invention relates particularly to a vertical inline production of substrates such as OLED-displays. The term 'inline production' refers to the situation that the substrate to be coated passes the evaporation unit at constant speed driven by a transportation unit such as a conveyor belt.

According to the present invention, the chambers 110 are adapted for receiving one or more evaporation units. During operation of the evaporation apparatus, typically all chambers are equipped with an evaporation unit. Figs. 3A to 3D each show an embodiment of a chamber of the rotatable evaporation unit receptacle of the evaporation apparatus according to the present invention being equipped with different evaporation units. In Fig. 3A the evaporation unit 310 is shown as an evaporation helix. Fig. 3A shows a horizontal cross-sectional view through the chamber 110. The evaporation helix 310 is oriented vertically within the chamber. That is, the axis of the helix is oriented vertically. Further to the helix 310 shown in Fig. 3A, a bar made of the material to be evaporated is shown in the centre of the helix. The evaporation material bar is referred to as reference number 320. Further, the reflection unit 300 is shown lining the side walls and the backside of the chamber 110.

The reflection unit may optionally be used with the evaporation apparatus according to the present invention. In typical embodiments, the reflection unit is heatable. Further, the optional reflector unit may be made of a sheet metal. The provision of a reflection unit within the chamber reduces the contamination of the chamber. Typical materials for the reflection unit are Tungsten, Tantalum, or Molybdenum. Typically, in operation the reflection unit is heated to a temperature of up to 1.600°. That is, the reflection unit is typically heatable up to 1.600°. Heating of the reflection unit can be achieved by applying a voltage to the reflection unit so that a current flows through the reflection unit thereby heating it. Hence, a typical reflection unit provides electrodes for a connection to a voltage. The provision of the reflection unit improves the evaporation distribution and quality.

According to another embodiment exemplarily shown with respect to Fig. 3B, the evaporation unit is arranged horizontally. Fig. 3B is a horizontal cross-section through the chamber 110 of the rotatable evaporation unit receptacle having a reflection unit 300 and being equipped with an evaporation helix 310 surrounding an evaporation material bar 320.

The embodiment of the chamber 110 shown in Fig. 3C is identical to the embodiment shown in Fig. 3A with the only difference that the evaporation unit is a vertically oriented crucible 330 instead of the evaporation helix 310 shown in Fig. 3A. Similarly, the embodiment of the chamber 110 shown in Fig. 3D is identical to the embodiment shown in Fig. 3B with the only difference that the evaporation unit is a horizontally oriented crucible 330 instead of the helix 310 as depicted in Fig. 3B.

In typical embodiments of the present invention, the evaporation unit is an evaporation helix. The evaporation helix may be made of Tungsten, Tantalum or Molybdenum. The evaporation helix may particularly be made of Tungsten, Tantalum or Molybdenum in those embodiments where Aluminum is evaporated. In embodiments where a crucible is used the crucible is typically made of ceramics or metal. In particular the crucible may be made of one or more materials selected from the group consisting of metallic boride, a metallic nitride such as titanium nitride, a metallic carbide, a non-metallic boride, a non-metallic nitride, a non-metallic carbide, nitrides, borides, graphite, and combinations thereof can be used (e.g., TiB₂, a combination of TiB₂ and AIN, a combination of TiB₂ and BN, or a combination of TiB₂, BN and AIN; B₄C or SiC). Typical lengths of an evaporation unit such as a crucible are in the range of 90 mm and 350 mm, more typically between 90 mm and 180 mm such as 130 mm, whereas typical widths of the crucible are in the range of 20 mm and 40 mm such as 30 mm. Typical heights of the crucible are in the range of 5 mm and 15 mm such as 10 mm.

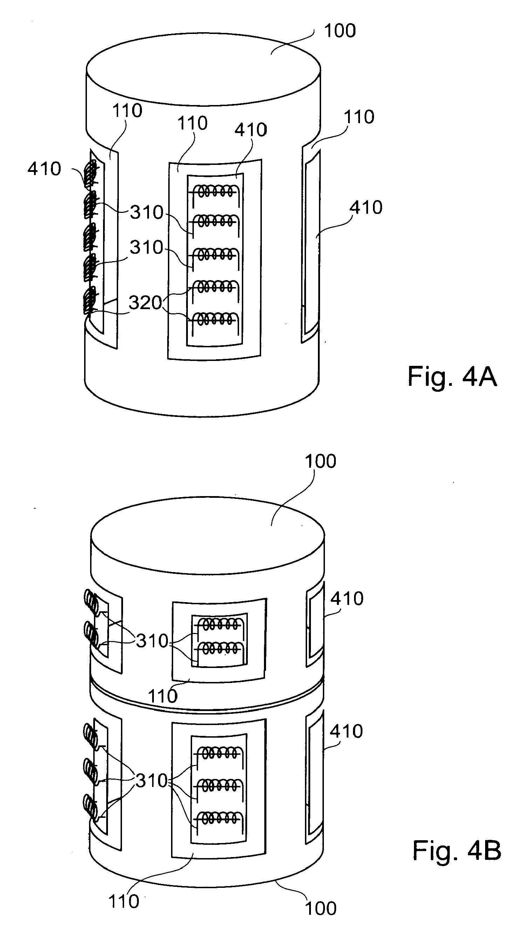

Fig. 4A shows an embodiment of the rotatable evaporation unit receptacle of the evaporation apparatus according to the present invention having four chambers each being equipped with a multitude of evaporation units. In the embodiment shown, each chamber is equipped with a mounting joist for mounting evaporation units thereon. In general, the evaporation unit(s) may be a crucible or evaporation helix which is shown in Fig. 4A. The mounting joist 410 may allow mounting the evaporation units in a vertical or horizontal orientation thereon. As an example, the evaporation helixes 310 with their respective material bars 320 are oriented vertically on the mounting joist 410 shown on the left of Fig. 4A whereas the evaporation helixes 310 with their material bars 320 are mounted in a horizontal orientation on the mounting joist shown in the middle of Fig. 4A.

The use of a multitude of evaporation units arranged vertically above each other is particularly interesting for the coating of large substrates. For instance, a glass substrate to be processed with the present invention may be of about 1,500 mm x 1,850 mm or even larger such as 2,500 mm in one dimension. Typically, each evaporation unit may be used for coating a height of 30 to 40 cm of the substrate. Hence, in order to coat a substrate having a height of 1,500 mm, several evaporation units have to be positioned above each other as this is exemplarily shown in Figs. 4A and 4B.

In general, an aperture unit may be positioned between evaporation unit and substrate. In the event of several evaporation units positioned above each other, a number of aperture units equal to the number of evaporation units may be provided. In general, the aperture unit is arranged such that it suppresses the centre of the evaporation distribution generated by the evaporation unit.

Fig. 4B shows another embodiment of a rotatable evaporation unit receptacle of an evaporation apparatus according to the present invention. The rotatable evaporation unit receptacle consists of two sub-evaporation unit receptacles. In general, each sub-evaporation unit receptacle may be adapted for receiving one or more evaporation units per chamber. The number of chambers per sub-evaporation unit receptacle is typically between two and six. In typical embodiments, the number of evaporation units per chamber is identical in all sub-evaporation unit receptacles. However, as exemplarily shown in Fig. 4B, it is also possible that the number of evaporation units per chamber differs between the sub-evaporation unit receptacles. Typically, each sub-evaporation unit receptacle can be individually addressed.

Two or more sub-evaporation unit receptacles may be positioned in respective sub-evaporation unit receptacle housings. Each housing can be of any shape and form described herein. This corresponds to a situation where several evaporation apparatuses according to the present invention are positioned above each other. Further, it is also possible that several sub-evaporation unit receptacles share one common evaporation unit receptacle housing.

Fig. 5A and Fig. 5B show cross-sections of two more embodiments of the evaporation unit receptacle of the evaporation apparatus according to the present invention. The evaporation unit receptacle 100 shown in Fig. 5A has three chambers 110 whereas the evaporation unit receptacle 100 shown in Fig. 5B has six chambers 110.

Fig. 6 shows an embodiment of the evaporation apparatus according to the present invention in a cross-sectional view. The rotatable evaporation unit receptacle 100 is equipped with four chambers 110. Each chamber can be provided with one or more evaporation units (not shown). Typically, the evaporation apparatus is located in ambient atmosphere. That is, the chamber at position I of Fig. 6 is exposed to ambient air. At this position of the evaporation unit receptacle, the evaporation unit can be refilled by e.g. refilling the material bar in the evaporation helix. This can be done manually or automatically. Moreover, this can be done during operation of the evaporation apparatus, i.e. whilst the evaporation unit at position III is in operation.

Coating the substrate has to be undertaken in a clean atmosphere having an acceptable level of low pressure. Therefore, the vacuum chamber 800 is linked to the evaporation unit receptacle housing of the evaporation apparatus in a sealed way. The vacuum chamber 800 is provided with one or more vacuum pump connections 810. The pump connection is typically connection to a vacuum pump (not shown). Further, the vacuum chamber comprises a transportation unit 830 on which the vertically oriented substrate 10 is transported from one side of the vacuum chamber to the other whilst it is coated by the evaporation unit positioned in the chamber at position III. Typically, the substrate 10 enters the vacuum chamber 800 from adjacent vacuum chambers or ambient air. Therefore, according to typical embodiments of the present invention, seals 820 are provided in the vacuum chamber 800 for the entering and exiting of the substrates.

Further, in typical embodiments of the evaporation apparatus one or more vacuum pump connections 250 are provided in the evaporation unit receptacle housing 210. These vacuum pump connections serve to pump air out of the evaporation unit receptacle housing. In particular, when the evaporation unit receptacle is pivoted at an angle of 90° so that the chamber at position I changes its position from position I to position II, the air present in this chamber due to its exposure to ambient air at position I is pumped off by vacuum pump connection 250. Therefore, the chamber is already at vacuum level when the evaporation unit receptacle is pivoted such that the chamber moves from position II to position III.

According to typical embodiments, the evaporation unit is already heated when it is located at position II. It is, however, only heated to such a temperature that no evaporation takes place, i.e. the material bar is melted such that the evaporation unit is only wetted. Typically, this temperature is in the range of 1,100°C and 1,200°C. Hence, once the evaporation unit receptacle is pivoted at another 90°, so that the evaporation unit moves forward to position III, evaporation can start immediately. In order to do so, the evaporation unit is further heated. Typical temperatures are between 1,300°C and 1,600°C such a 1,560°C. Thereby, a vapour is generated and partly condenses on the substrate. Typically, the substrate is continuously moved in front of the evaporation unit at position III. However, in particular for thick-film coatings, which shall be understood as coatings thicker than 100 nm, more typically in the range of 200 nm and 400 nm, the substrate speed is typically below 1.0 m/min, more typically below 0.8 m/min. In general, depending on the application, the substrate may rest for a predetermined time in front of the evaporation unit. In order to achieve a thick-film coating it is more typical to reduce the substrate speed and/or to position several evaporation apparatuses according to the present invention horizontally adjacent to each other along the substrate's transportation direction.

In general, as typical parameters for the operation of the evaporation apparatus according to the present invention, one ore more of the following exemplary parameter intervals may be chosen: The size of the coating window may be between 20 nm and 400 nm, more typically between 50 mm and 200 mm. The size of the coating window refers to the maximal horizontal length on the substrate that can be coated if the substrate is assumed to rest. The substrate transport speed can be chosen between 0.5 m/min and 1.5 m/min, typically between 0.8 m/min and 1.2 m/min. Typical coating thicknesses desired are between 100 nm and 600 nm, more typically between 200 nm and 400 nm. Coating rates is typically between 125 nm/min and 10 mm/min, more typically between 80 nm/min and 9,600 nm/min such as 300 nm/min (the coating rate can be calculated as the desired coating thickness times the substrate speed per size of the coating window).

During evaporation, the material to be evaporated is consumed. For instance, in the case of an evaporation helix, the amount of remaining material of the material bar can be measured by measuring the resistance of the bar. Once a certain level of remaining material is underrun it has to be refilled. In order to do so, the rotatable evaporation unit receptacle 100 is turned once more. In the case of four chambers, it is turned at 90°. Thereby, the evaporation unit with the consumed material moves from position III to position IV. At this position, the evaporation unit can cool down. Hence, when the evaporation unit receptacle is pivoted once more so that the evaporation unit with the consumed material moves to position I it is already cooled down so that it can easily be handled. Handling in this context shall comprise refilling the consumed material or replacing the whole evaporation unit.

In summation, the provision of several chambers in the rotatable evaporation unit receptacle of the evaporation apparatus according to the present invention allows the semi-continuous evaporation of substrates. The rate at which the evaporation unit receptacle has to be pivoted depends on the interval within which the material to be coated is consumed during evaporation. Typically, evaporation can take place for between 0.1 hours to 1.5 hours, more typically between 0.25 hours and 0.5 hours before the material has to be refilled or the evaporation unit has to be replaced. This time period is determined by the size of the evaporation unit, the amount of the evaporation material supplied to the evaporation unit, and the evaporation rate at which evaporation takes place. The rotatable evaporation unit receptacle remains static for this period of time. As discussed before, during the interval, within which the evaporation unit at position III is operated in order to coat the substrate(s), the evaporation unit at position II can already be heated whereas the evaporation unit at position IV can cool down for a better handling at later position I.

Once the material is consumed, the evaporation unit receptacle is rotated so that the next chamber being equipped with a refilled evaporation unit is exposed to the vacuum chamber for coating the substrates. In the event of four chambers, the evaporation unit receptacle is pivoted at 90°. In the event of only two chambers, the evaporation unit receptacle is pivoted at 180°. In the event of three chambers, the evaporation unit receptacle is pivoted at 120°. In general, in the event of n chambers the evaporation unit receptacle is pivoted at 360°/n with n being an integer larger or equal to 2, most typical with n being equal to 4.

Hence, in typical embodiments of the evaporation apparatus according to the present invention, the evaporation unit receptacle housing comprises two openings with one opening being exposed to ambient air and the other opening being exposed to vacuum. Therefore, the evaporation apparatus typically comprises one or more gaskets for sealing. In general, seals are provided at the top of the evaporation unit receptacle, at the bottom of the evaporation unit receptacle, and along the side wall of the evaporation unit receptacle or evaporation unit receptacle housing. It is possible that the respective gasket is static or it moves along with the evaporation unit receptacle if the evaporation unit receptacle is pivoted. If the respective gasket is static, it is typically fixed to the evaporation unit receptacle housing. If the gasket moves along with the evaporation unit receptacle it is typically fixed to the evaporation unit receptacle. If the gasket is adapted for providing a sealing between evaporation unit receptacle and evaporation unit receptacle housing along the evaporation unit receptacle housing inner wall, it may be advantageous to fix the gasket to the housing instead of the evaporation unit receptacle. This is as in the latter case the gasket is exposed to the vapour when the evaporation unit receptacle is rotated. The gasket extending vertically along the evaporation unit receptacle or the evaporation unit receptacle housing is called "sealing lip" within the present application.

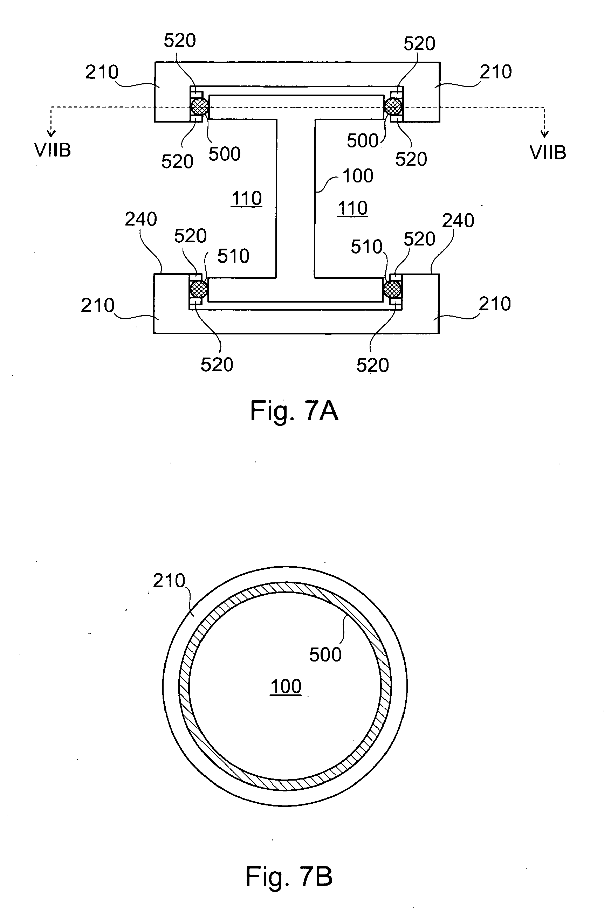

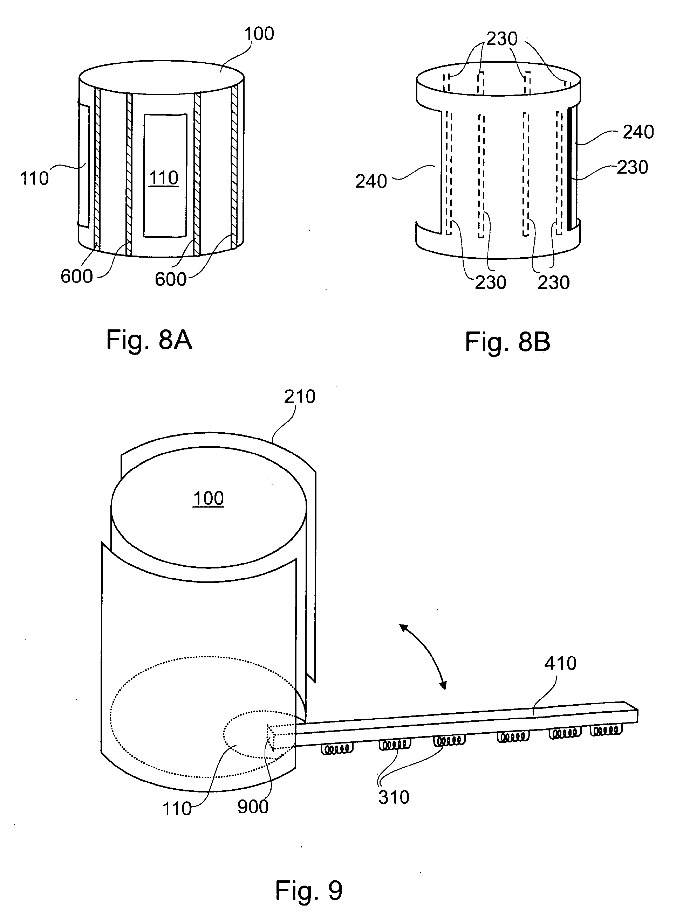

In the following, exemplary embodiments of gaskets at the top and the bottom of the evaporation unit receptacle are described with respect to Figs. 7A and 7B whereas Figs. 8A and 8B are exemplary embodiments of the sealing lip along the side walls of the evaporation unit receptacle and the evaporation unit receptacle housing.

Fig. 7A shows a cross-sectional view of an embodiment of the evaporation apparatus according to the present invention. In contrary to the embodiments shown in Figs. 1A, 1B, 2A to 2D, 3A to 3D, 5A, 5B and 6, which have been shown in a horizontal cross-sectional view, the cross-section shown in Fig. 7A is a vertical cross-sectional view. The rotatable evaporation unit receptacle 100 comprises the chamber 110 for being equipped with one or more evaporation units. The evaporation unit receptacle 100 is surrounded by the evaporation unit receptacle housing 210. The evaporation unit receptacle housing 210 comprises the evaporation unit receptacle housing opening 240. For instance, this opening can be used for refilling the consumed material in the evaporation unit that can be positioned in chamber 110. In order to seal the vacuum chamber used for coating substrates (not shown in Fig. 7A) from the high atmospheric pressure at the opening 240, an upper gasket 500 between evaporation unit receptacle and evaporation unit receptacle housing is provided and a lower gasket 510 between evaporation unit receptacle and evaporation unit receptacle housing is provided. As shown, the gaskets 500 and 510 are fixed to the evaporation unit receptacle housing 210 by means of the gasket fastener 520. That is, in this embodiment the gaskets 500 and 510 are static. According to another embodiment (not shown) the gaskets 500 and 510 could be fixed to the evaporation unit receptacle 100. In this case, the gaskets 500 and 510 would move along with the rotatable evaporation unit receptacle when the evaporation unit receptacle is rotated.

In general, the upper gasket between the top of the evaporation unit receptacle and the evaporation unit receptacle housing, and/or the lower gasket between the bottom of the evaporation unit receptacle and the evaporation unit receptacle housing are annular gaskets. In the event of annular gaskets, they typically surround the complete evaporation unit receptacle. This is illustrated in Fig. 7B showing a horizontal cross-sectional view of the evaporation apparatus that is partly shown in Fig. 7A along the dotted line VIIB. The annular gasket 500 is sandwiched between the evaporation unit receptacle 100 and the evaporation unit receptacle housing 210. An identical figure could be depicted with the annular lower gasket 510 being sandwiched between evaporation unit receptacle housing 210 and evaporation unit receptacle 100. Typical materials for the gaskets used according to the present invention are rubber, polyamides (PA), polyethylenes (PE) and polytetrafluoroethylene (PTFE)-compounds. In particular, according to typical embodiments of the present invention, the horizontally oriented gaskets, which are typically annular gaskets, are made of PTFE-compounds and/or the vertically oriented sealing lips are made of PE or PA.

The embodiments shown in Figs. 8A and 8B relate to the vertically oriented sealing lips along the side walls of the evaporation unit receptacle (Fig. 8A) or the evaporation unit receptacle housing (Fig. 8B). The sealing lips 600 shown in Fig. 8A are fixed to the evaporation unit receptacle. The evaporation unit receptacle of this embodiment comprises four chambers and eight sealing lips 600 (four sealing lips and two chambers are not visible in the perspective of Fig. 8A) positioned between the chambers. In general, the number of sealing lips that the evaporation unit receptacle may be equipped with is typically twice the number of chambers. It is typical that at least two sealing lips are provided between adjacent chambers. The height of the sealing lip may be identical to the height of the evaporation unit receptacle. In other embodiments, the height of the sealing lips is such that the vertical sealing lips contact the horizontally oriented annular gaskets positioned between the top of the evaporation unit receptacle and evaporation unit receptacle housing and the bottom of the evaporation unit receptacle and the evaporation unit receptacle housing. In the embodiment shown in Fig. 8A, the vertically oriented sealing lips move along with the evaporation unit receptacle if it is rotated.

Fig. 8B shows an embodiment of the evaporation unit receptacle housing according to the present invention. According to this embodiment, the vertically oriented sealing lips are fixed to the inner wall of the evaporation unit receptacle housing. The position of at least four of the sealing lips 230 may be close to the housing openings. In Fig. 8B this is indicated by the dotted lines and the sealing lip 230 on the right hand side of the drawing which can be seen through the housing opening 240 (thick black line). Further, the sealing lips 230 are also shown in the cross-sectional views of Figs. 2B to 2D.

In typical embodiments of the present invention, the pivoting of the evaporation unit receptacle is synchronized with the supply of substrates. Typically, the change from one chamber to the other, i.e. the pivoting of the evaporation unit receptacle, takes place at the time interval in which a new substrate is driven into the evaporation chamber. Depending on the amount of material provided with the evaporation unit and the amount needed in order to reach the desired coating thickness it is possible that several substrates can be coated without a change of the evaporation unit.

According to the present invention, the evaporation unit can be displaced from the chamber in order to refill the evaporation material or to replace the evaporation unit. In order to do so, the chamber may be provided with means for mounting and dismounting the evaporation unit.

The present invention allows a semi-continuous thermal coating of substrates and overcomes the need for airing the evaporation chamber when the evaporation unit is refilled or replaced. It is possible to provide means for automatically refilling and/or replacing the evaporation unit. These means can be placed in ambient atmosphere. In the embodiment shown in Fig. 6, these means would be positioned adjacent to the chamber of position I. Further, as the evaporation apparatus according to the present invention can be equipped with an evaporation unit receptacle and a multitude of chambers each adapted for receiving a multitude of evaporation units (compare the embodiments shown in Fig. 4A and 4B) it is theoretically possible to coat arbitrary large substrates with the evaporation apparatus according to the present invention. Another possibility of how to coat large substrates is to build up a stack of several evaporation apparatuses according to the present invention. In theory, an arbitrary height can be reached this way.

The evaporation apparatus according to the present invention may comprise flap means for replacing the evaporation unit or refilling the evaporation material. This is exemplarily illustrated in Fig. 9. The evaporation unit receptacle 100 is positioned within the evaporation unit receptacle housing 210. The evaporation unit receptacle may have two, three, four or more chambers. In Fig. 9, only one chamber is shown. One or more evaporation units are arranged in the chambers 110. In the embodiment shown in Fig. 9, the six evaporation helixes 310 are mounted to the mounting bar 410. For refilling the material or replacing some or all evaporation units, it is possible to flap the mounting bar from the vertically oriented position within the chamber down to a horizontally oriented position as it is shown in Fig. 9. The mounting bar bottom is fixed to the chamber with the help of flap means that allow flapping the mounting bar out of the chamber. In the horizontal position, the evaporation material can be easily refilled or the evaporation unit can easily be replaced. After refilling or replacing, the mounting bar can be put back to the vertical position within the chamber 110. The time interval for refilling or replacing is typically at least half an hour. This is the typical time interval for the evaporation with the same evaporation material until the material is consumed. The flap means can be, for instance, a hinge, which is typically positioned in the chamber bottom, cooperating with a catch (not shown) for locking the mounting bar in the vertical position within the chamber. The catch is typically positioned at or close to the top of the chamber.

In operation, the evaporation apparatus enables thin or thick film forming a material on a substrate. The evaporation apparatus and the method according to the present invention are typically used in the production of OLEDs. According to typical embodiments described herein, the material to be vapor deposited on the substrate can be a metal like Aluminum, Gold, Copper, or alloys including at least one of these metals. Typical coating thicknesses are between 200 nm and 400 nm.

The material to be deposited is melted and evaporated by heating the evaporation unit. Heating can be conducted by providing a power source (not shown) connected to the first electrical connection and the second electrical connection of the evaporation unit. For instance, these electrical connections may be electrodes made of copper or an alloy thereof. Thereby, heating is conducted by the current flowing through the body of the evaporation unit. Typically, a direct-current voltage of between 5 V and 20 V, more typically between 10 V and 14 V is applied to the evaporation unit. According to other embodiments, heating may also be conducted by an irradiation heater of an evaporation apparatus or an inductive heating unit of an evaporation apparatus.

As shown in the Figures, in typical embodiments of the present invention, the evaporation apparatus is used for vertical evaporation, i.e. with the substrate 10 being vertically arranged. According to typical embodiments of the vertical evaporator according to the present invention, the substrate 10 travels horizontally past the one or more evaporation unit(s). Thereby, the evaporation apparatus according to the present invention provides a continuous coating process of the vertically arranged substrate in the horizontal direction. This continuous coating shall be called "in-line coating" within the present application. Typically, the speed of the substrates is in the range of between 20 cm/min and 200 cm/min, more typically between 80 cm/min and 120 cm/min such as 100 cm/min. In these cases, the transportation unit, which is exemplarily shown in Fig. 6 and referred to as number 830, should be capable of transporting the substrate at those speeds.

It is further generally possible to position an aperture unit (not shown) between the evaporation crucible and the substrate. The aperture unit helps in further avoiding undesired irregularities in the coating thickness. Typical aperture sizes are in the range of 50 mm and 200 mm. Typical aperture shapes are curved. Typically, the aperture is symmetrical in the vertical direction. The aperture is typically positioned such that the center of the evaporation distribution is suppressed. This is due to the fact that, in general, the coating on the substrate shall be as homogeneous as possible and the evaporation distribution is maximal in the center of the distribution.

As a further example, the embodiments described herein can be utilized for the coating of substrates for display technology or the like. Thereby, substrate size may be as follows. A typical glass substrate and, thereby, also a coating area can have dimensions of about 0.7 mm x 500 mm x 750 mm. Yet, the substrates that can be processed with the present invention can also have a size of about 1500 mm x 1850 mm or even larger such as 2500 mm in one direction.

While the foregoing is directed to embodiments of the invention, other and further embodiments of the invention may be devised without departing from the basic scope thereof, and the scope thereof is determined by the claims that follow.

## Claims

1. Evaporation apparatus having a rotatable evaporation unit receptacle (100) with a multitude of chambers (110) wherein each of the chambers is adapted for receiving at least one evaporation unit (310;330).

2. Evaporation apparatus according to any of the preceding claims wherein the multitude of chambers comprises at least four chambers (110).

3. Evaporation apparatus according to any of the preceding claims further comprising an evaporation unit receptacle housing (210) surrounding at least a part of the rotatable evaporation unit receptacle (100) with the evaporation unit receptacle housing having a first opening (220) and a second opening (240).

4. Evaporation apparatus according to claim 3 further comprising at least one vacuum pump connection (250) for exhausting air from within the evaporation unit receptacle housing.

5. Evaporation apparatus according to claim 3 or 4, further comprising a sealing lip (230; 600) positioned between the rotatable evaporation unit receptacle and the evaporation unit receptacle housing.

6. Evaporation apparatus according to any of claims 3 to 5, wherein the first opening (220) is connected to a vacuum chamber (800).

7. Evaporation apparatus according to any of the preceding claims, further comprising a lower gasket (510) and an upper gasket (500).

8. Evaporation apparatus according to any of the preceding claims wherein at least one chamber comprises a reflection unit (300).

9. Evaporation apparatus according to claim 8 wherein the reflection unit (300) is made of tungsten, tantalum, or molybdenum.

10. Evaporation apparatus according to any of the preceding claims wherein at least one chamber is provided with an evaporation unit (310; 330).

11. Evaporation apparatus according to any of the preceding claims wherein the evaporation unit is a heatable evaporation helix (310) for receiving evaporation material (320).

12. Evaporation apparatus according to claim 11 wherein the evaporation helix (310) is made of tungsten, tantalum, or molybdenum.

13. Evaporation apparatus according to any of claims 1-10 wherein the evaporation unit is a heatable crucible (330) for receiving evaporation material.

14. Evaporation apparatus according to claim 13 wherein the crucible is made of one ore more materials selected from the group consisting of a metallic boride, a metallic nitride such as titanium nitride, a metallic carbide, a non-metallic boride, a non-metallic nitride, a non-metallic carbide, nitrides, borides, graphite, B₄C, SiC, TiB₂, a combination of TiB₂ and AIN, a combination of TiB₂ and BN, or a combination of TiB₂, BN and AIN.

15. Evaporation apparatus according to any of the preceding claims wherein at least one chamber further comprises flap means for replacing the evaporation unit and/or material to be evaporated.

16. Evaporation apparatus according to any of the preceding claims wherein at least one chamber comprises a multitude of evaporation units arranged above each other.

17. Evaporation apparatus according to any of the preceding claims having at least two rotatable evaporation unit receptacles.

18. Method for coating substrates with the steps of:
- placing an evaporation unit in a chamber of an evaporation apparatus evaporation unit receptacle, the chamber having a first atmosphere; and
- rotating an evaporation unit receptacle so that the chamber is in a second atmosphere.

19. Method according to claim 18 wherein the second atmosphere is vacuum.

20. Method according to any of claims 18 to 19, wherein the first atmosphere is ambient atmosphere.

21. Method according to any of claims 18 to 20, further comprising the step of pumping air from the chamber.

22. Method according to any of claims 18 to 21, further comprising the step of coating at least one substrate with material.

23. Method according to any of claims 18 to 22, wherein the evaporation unit is an evaporation helix or a crucible.

24. Method according to any of claims 18 to 23 with the further step of refilling the evaporation unit with evaporation material, or replacing the evaporation unit.

## Amended claims

### Amended claims in accordance with Rule 137(2) EPC.

**1.** Evaporation apparatus having a rotatable evaporation unit receptacle (100) with a multitude of chambers (110) wherein each of the chambers is adapted for receiving at least one evaporation unit (310;330).

**2.** Evaporation apparatus according to any of the preceding claims wherein the multitude of chambers comprises at least four chambers (110).

**3.** Evaporation apparatus according to any of the preceding claims further comprising an evaporation unit receptacle housing (210) surrounding at least a part of the rotatable evaporation unit receptacle (100) with the evaporation unit receptacle housing having a first opening (220) and a second opening (240).

**4.** Evaporation apparatus according to claim 3 further comprising at least one vacuum pump connection (250) for exhausting air from within the evaporation unit receptacle housing.

**5.** Evaporation apparatus according to claim 3 or 4, further comprising a sealing lip (230; 600) positioned between the rotatable evaporation unit receptacle and the evaporation unit receptacle housing.

**6.** Evaporation apparatus according to any of claims 3 to 5, wherein the first opening (220) is connected to a vacuum chamber (800).

**7.** Evaporation apparatus according to any of the preceding claims, further comprising a lower gasket (510) and an upper gasket (500).

**8.** Evaporation apparatus according to any of the preceding claims wherein at least one chamber comprises a reflection unit (300).

**9.** Evaporation apparatus according to claim 8 wherein the reflection unit (300) is made of tungsten, tantalum, or molybdenum.

**10.** Evaporation apparatus according to any of the preceding claims wherein at least one chamber is provided with an evaporation unit (310; 330).

**11.** Evaporation apparatus according to any of the preceding claims wherein the evaporation unit is a heatable evaporation helix (310) for receiving evaporation material (320).

**12.** Evaporation apparatus according to claim 11 wherein the evaporation helix (310) is made of tungsten, tantalum, or molybdenum.

**13.** Evaporation apparatus according to any of claims 1-10 wherein the evaporation unit is a heatable crucible (330) for receiving evaporation material.

**14.** Evaporation apparatus according to claim 13 wherein the crucible is made of one ore more materials selected from the group consisting of a metallic boride, a metallic nitride such as titanium nitride, a metallic carbide, a non-metallic boride, a non-metallic nitride, a non-metallic carbide, nitrides, borides, graphite, B₄C, SiC, TiB₂, a combination of TiB₂ and AIN, a combination of TiB₂ and BN, or a combination of TiB₂, BN and AlN.

**15.** Evaporation apparatus according to any of the preceding claims wherein at least one chamber further comprises flap means for replacing the evaporation unit and/or material to be evaporated.

**16.** Evaporation apparatus according to any of the preceding claims wherein at least one chamber comprises a multitude of evaporation units arranged above each other.

**17.** Evaporation apparatus according to any of the preceding claims having at least two rotatable evaporation unit receptacles.

**18.** Method for coating substrates with the steps of:
- placing an evaporation unit in a chamber of an evaporation apparatus having a rotatable evaporation unit receptacle, the chamber having a first atmosphere; and
- rotating an evaporation unit receptacle so that the chamber is in a second atmosphere.

**19.** Method according to claim 18 wherein the second atmosphere is vacuum.

**20.** Method according to any of claims 18 to 19, wherein the first atmosphere is ambient atmosphere.

**21.** Method according to any of claims 18 to 20, further comprising the step of pumping air from the chamber.

**22.** Method according to any of claims 18 to 21, further comprising the step of coating at least one substrate with material.

**23.** Method according to any of claims 18 to 22, wherein the evaporation unit is an evaporation helix or a crucible.

**24.** Method according to any of claims 18 to 23 with the further step of refilling the evaporation unit with evaporation material, or replacing the evaporation unit.
